# EUROPÄISCHE PATENTSCHRIFT

(11) **EP 1 929 522 B1**
(45) Veröffentlichungstag und Bekanntmachung des Hinweises auf die Patenterteilung: **15.04.2009**
(21) Anmeldenummer: 06805801.5
(22) Anmeldetag: 21.09.2006
(51) Int. Cl.: H01L 23/522

(54) **INTEGRIERTE SCHALTUNG MIT MINDESTENS EINER INTEGRIERTEN TRANSMISSIONSLEITUNG**
INTEGRATED CIRCUIT COMPRISING AT LEAST ONE INTEGRATED TRANSMISSION LINE
CIRCUIT INTEGRE COMPRENANT AU MOINS UNE LIGNE DE TRANSMISSION INTEGREE

(30) Priorität: 26.09.2005 DE 102005046009
(43) Veröffentlichungstag der Anmeldung: 11.06.2008
(73) Patentinhaber: ATMEL Duisburg GmbH, 47057 Duisburg (DE)
(72) Erfinder: EL RAI, Samir, 40233 Düsseldorf (DE); TEMPEL, Ralf, 47058 Duisburg (DE)
(74) Vertreter: Müller, Wolf-Christian
(86) Internationale Anmeldenummer: PCT/EP2006/009189
(87) Internationale Veröffentlichungsnummer: WO 2007/036323

(56) Entgegenhaltungen:
- WO-A-95/06946
- US-A- 5 357 050
- US-A- 5 357 051
- US-A- 5 459 284
- US-A1- 2002 079 587
- US-B1- 6 396 000

## Beschreibung

Die vorliegende Erfindung betrifft eine integrierte Schaltung mit mindestens einer integrierten Transmissionsleitung nach dem Oberbegriff des Patentanspruchs 1.

Die Erfindung liegt auf dem Gebiet von integrierten Halbleiter-Schaltungen (integrated circuit, IC). Sie liegt insbesondere auf dem Gebiet von in solchen Schaltungen integrierten Transmissionsleitungen zur Übertragung von hochfrequenten elektrischen Signalen.

Zur Übertragung von hochfrequenten differentiellen Signalen werden üblicherweise symmetrisch aufgebaute Transmissionsleitungen verwendet, die zwei geradlinige, in einem bestimmten Abstand zueinander angeordnete Leitungsstränge aufweisen. Die elektrische Länge einer solchen klassischen Transmissionsleitung, die proportional zur Phasenverschiebung des zu übertragenden Signals ist, liegt in der Größenordnung der Wellenlänge des Signals. Bei einer Frequenz von z.B. 30 GHz beträgt die Wellenlänge im freien Raum 10mm, während sich z.B. bei 3 GHz eine Wellenlänge von 100mm ergibt.

Das in der Druckschrift WO95/06946 A offenbarte Verfahren zeigt eine integrierte Schaltung, die eine Transmissionsleitung zur Übertragung eines differentiellen Signals beinhaltet. Hierbei schwächen sich die Magnetfelder im Außenraum um die Leiterbahnen.

Die Eigenschaften, wie z.B. der Wellenwiderstand (Impedanz), die Ausbreitungskonstante bzw. Güte (Q-Faktor) etc. einer klassischen Transmissionsleitung können verändert werden, indem der Querschnitt der Leitungsstränge, ihr Abstand zueinander, ihr Abstand zur Masse und/oder die Dielektrizitätskonstante des umgebenden Mediums variiert werden. Die geometrische Länge einer klassischen Transmissionsleitung, d.h. ihre Abmessung in Signalausbreitungsrichtung, kann durch derartige Maßnahmen jedoch nicht entscheidend verändert werden.

Soll eine Transmissionsleitung auf einem Halbleiter-Chip (IC) integriert werden, so steht hierfür nur eine sehr kleine Fläche zur Verfügung, deren Dimensionen deutlich kleiner sind als die mit den oben genannten Maßnahmen erreichbaren geometrischen Längen klassischer Transmissionsleitungen.

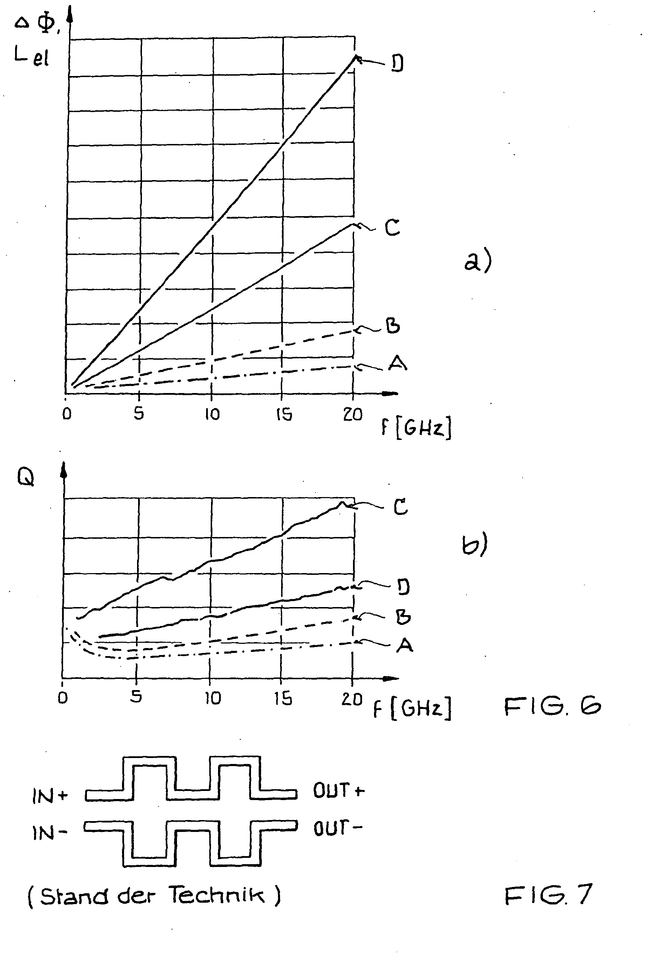

Um auf einer Fläche mit vorgegebenen Dimensionen größere Leitungslängen realisieren zu können, werden die Leitungen üblicherweise mäanderförmig ausgeführt, wie in Figur 7 schematisch dargestellt ist. Nachteilig ist hierbei, daß im Vergleich zur klassischen Transmissionsleitung bei gleicher geometrischer Länge der gestreckten Leitungsstränge infolge der Mäanderform die Güte der Transmissionsleitung sinkt und damit ihre Einfügedämpfung steigt. Außerdem kann die geometrische Leitungslänge pro Flächeneinheit durch diesen Ansatz allenfalls verdoppelt werden. Aufgrund zu niedriger Werte der elektrischen Länge bzw. der Phasenverschiebung ist es nicht möglich, mäanderförmige Transmissionsleitungen zur Übertragung von Signalen im Frequenzbereich von deutlich unter 30 GHz auf einem IC zu integrieren.

Vor diesem Hintergrund liegt der Erfindung die Aufgabe zugrunde, eine integrierte Schaltung mit mindestens einer einfach und kostengünstig zu implementierenden integrierten Transmissionsleitung anzugeben, die eine hohe Güte bzw. eine geringe Einfügedämpfung sowie eine große elektrische Länge bzw. Phasenverschiebung aufweist und große geometrische Leitungslängen pro Flächeneinheit ermöglicht, so daß auch Signale im Frequenzbereich von deutlich unter 30 GHz, z.B. zwischen ca. 2 GHz und 20 GHz, in einer integrierten Schaltung übertragen werden können.

Erfindungsgemäß wird diese Aufgabe gelöst durch die Merkmale des Patentanspruchs 1.

Die erfindungsgemäße integrierte Schaltung mit mindestens einer integrierten Transmissionsleitung zur Übertragung eines hochfrequenten differentiellen Signals beinhaltet eine Anzahl von mindestens zwei in Reihe geschalteten Leitungsanordnungen, die jeweils einen differentiellen Eingang, einen differentiellen Ausgang, eine mit einem ersten Pol des differentiellen Eingangs und einem ersten Pol des differentiellen Ausgangs verbundene erste Leiterbahn und eine mit einem zweiten Pol des differentiellen Eingangs und einem zweiten Pol des differentiellen Ausgangs verbundene zweite Leiterbahn aufweisen, wobei jede Leitungsanordnung mindestens zwei Kreuzungsbereiche, in denen sich die erste und die zweite Leiterbahn kreuzen, und mindestens vier Mitkopplungsbereiche aufweist, in denen jeweils mindestens ein erster Abschnitt der ersten Leiterbahn derart in einem kleinen ersten Abstand zu mindestens einem zweiten Abschnitt der zweiten Leiterbahn angeordnet ist, daß sich im die ersten und zweiten Abschnitte umgebenden Außenraum die Magnetfelder, die durch die Ströme hervorgerufen werden, die in den ersten und zweiten Abschnitten fließen, wenn das hochfrequente differentielle Signal am differentiellen Eingang der Leitungsanordnung anliegt, gegenseitig verstärken.

Das Wesen der Erfindung besteht darin, mindestens zwei in Reihe geschaltete Leitungsanordnungen mit jeweils zwei Leiterbahnen vorzusehen, die so ausgestaltet sind, daß im beide Leiterbahnen umgebenden (radialen) Außenraum die magnetischen Verstärkungseffekte groß gehalten werden und im Innenraum zwischen beiden Leiterbahnen die magnetischen Verluste bzw. die Stromverdrängung klein gehalten werden. Dies wird erreicht, indem erste und zweite Leiterbahnabschnitte derart in einem kleinen ersten Abstand zueinander angeordnet werden, daß sie gleichsinnig von Strömen durchflossen werden, wenn das hochfrequente differentielle Signal am differentiellen Eingang der Leitungsanordnung anliegt. In diesen "Mitkopplungsbereichen" der Leitungsanordnung verstärken sich hierdurch die Magnetfelder im die ersten und zweiten Leiterbahnabschnitte umgebenden Außenraum wesentlich. Damit erhöht sich die magnetische Kopplung zwischen den Leiterbahnen, so daß die Güte der Transmissionsleitung steigt bzw. ihre Einfügedämpfung sinkt und sich die elektrische Länge bzw. die Phasenverschiebung erhöht. Aufgrund ihrer Zusammensetzung aus mindestens zwei in Reihe geschalteten Leitungsanordnungen weist die Transmissionsleitung vorteilhaft homogene übertragungseigenschaften auf. Weiterhin ist sie einfach und kostengünstig zu implementieren.

In einer vorteilhaften Ausgestaltung verlaufen der mindestens eine erste Abschnitt und der mindestens eine zweite Abschnitt im wesentlichen parallel zueinander. Hierdurch steigt die magnetische Kopplung und damit die Phasenverschiebung und die Güte der Transmissionsleitung.

Gemäß einer weiteren vorteilhaften Ausgestaltung sind die Leitungsanordnungen untereinander im wesentlichen identisch. Hierdurch ist z.B. der Wellenwiderstand (Impedanz) und die Güte (Q-Faktor) der Transmissionsleitung identisch mit dem Wellenwiderstand bzw. der Güte jeder einzelnen Leitungsanordnung. Die elektrische Länge und die Phasenverschiebung der gesamten Transmissionsleitung ergibt sich, indem die elektrische Länge bzw. die Phasenverschiebung einer einzelnen Leitungsanordnung mit der Anzahl der vorhandenen Leitungsanordnungen multipliziert wird. Indem die Eigenschaften der Transmissionsleitung auf einfache Art und weise von den Eigenschaften jeder einzelnen Leitungsanordnung abgeleitet werden können, kann die Transmissionsleitung einfach und kostengünstig entwickelt und wegen der im wesentlichen identischen Wiederholung der Leitungsanordnungen einfach implementiert werden.

In einer vorteilhaften Ausgestaltung ist jede Leitungsanordnung derart ausgestaltet, daß die ersten und zweiten Abschnitte zusammen eine Gesamtlänge aufweisen, die einem hohen Anteil der Gesamtlänge der ersten und der zweiten Leiterbahn dieser Leitungsanordnung entspricht. Vorzugsweise beträgt dieser Anteil mindestens ein Drittel. Indem insgesamt ein hoher Anteil der Leiterbahnabschnitte in die Mitkopplungsbereiche fällt, steigen die magnetische Kopplung zwischen den Leiterbahnen und damit die elektrische Länge sowie die Güte weiter an, während die Einfügedämpfung weiter sinkt.

In einer weiteren Ausgestaltung nimmt der erste Abstand einen Wert an, der 50% bis 200%, vorzugsweise 100% der Breite der ersten Leiterbahn entspricht.

In einer weiteren Ausgestaltung sind in den Mitkopplungsbereichen jeder Leitungsanordnung zwischen der ersten Leiterbahn und der zweiten Leiterbahn insgesamt mindestens zwei kapazitive Elemente angeordnet (geschaltet). Hierdurch wird vorteilhaft der Kapazitätsbelag der Transmissionsleitung erhöht, so daß die Dämpfung der Transmissionsleitung weiter sinkt und die elektrische Länge bzw. die Phasenverschiebung weiter steigen.

Vorteilhaft weisen die mindestens zwei kapazitiven Elemente mindestens einen Kondensator, vorzugsweise mindestens einen MIM-Kondensator (metal insulator metal) hoher Güte auf.

Vorteilhaft weisen die mindestens zwei kapazitiven Elemente mindestens ein Element variabler Kapazität, vorzugsweise einen Varaktor oder einen kapazitiven Digital/Analog-Wandler (capacitive digital-to-analog converter, CDAC) auf. Hierdurch können die Eigenschaften der Transmissionsleitung vorteilhaft nach deren Herstellung mittels eines elektrischen Steuersignals verändert bzw. eingestellt werden.

In einer weiteren Ausgestaltung sind in den Mitkopplungsbereichen jeder Leitungsanordnung zwischen der ersten Leiterbahn und der zweiten Leiterbahn insgesamt mindestens zwei Verstärkungselemente angeordnet. Vorteilhaft handelt es sich hierbei um uni- oder bipolare Transistoren. Hierdurch erhält man eine aktive Transmissionsleitung, die vorteilhaft wie ein verteilter Verstärker wirkt.

Gemäß einer weiteren vorteilhaften Ausgestaltung ist jede Leitungsanordnung derart ausgestaltet, daß insgesamt ein großer Anteil, vorzugsweise mindestens 1/3, der von der Leitungsanordnung insgesamt belegten Fläche durch die erste oder die zweite Leiterbahn belegt wird. Hierdurch wird die zur Verfügung stehende Chipfläche effizient genutzt. Pro Flächeneinheit werden so größere geometrische Längen (Abmessungen) der gestreckten Leiterbahnen und damit auch größere elektrische Längen und höhere Güten erreicht, so daß auch Signale im Frequenzbereich von deutlich unter 30 GHz übertragen werden können.

Gemäß einer weiteren vorteilhaften Ausgestaltung ist jede Leitungsanordnung derart ausgestaltet, daß die erste Leiterbahn und die zweite Leiterbahn jeweils mindestens zwei Schleifen bilden und die Schleifen der ersten Leiterbahn teilweise innerhalb der Schleifen der zweiten Leiterbahn liegen und diese teilweise umfassen. Hierdurch wird die zur Verfügung stehende Chipfläche effizient genutzt. Die magnetische Kopplung erhöht sich vorteilhaft weiter.

In einer weiteren vorteilhaften Ausgestaltung ist jede Leitungsanordnung derart ausgestaltet, daß sich die Ströme, die jeweils in direkt benachbarten Leiterbahnabschnitten fließen, wenn das hochfrequente differentielle Signal am differentiellen Eingang der Leitungsanordnung anliegt, in keinem der direkt benachbarten Leiterbahnabschnitte gegenseitig wesentlich verdrängen. Hierdurch werden magnetische Verluste und damit die Einfügedämpfung reduziert. Unter dem Ausdruck "direkt benachbart" soll hier verstanden werden, daß kein anderer (weiterer) Leiterbahnabschnitt zwischen dem dritten und dem vierten Abschnitt angeordnet ist.

In einer weiteren vorteilhaften Ausgestaltung weist jede Leitungsanordnung Gegenkopplungsbereiche auf, in denen jeweils ein dritter Abschnitt der ersten oder zweiten Leiterbahn derart in einem größeren zweiten Abstand zu einem direkt benachbarten vierten Abschnitt der ersten oder zweiten Leiterbahn angeordnet ist, daß sich im Innenraum zwischen den dritten und vierten Abschnitten die Magnetfelder, die durch die Ströme hervorgerufen werden, die in den dritten und vierten Abschnitten fließen, wenn das hochfrequente differentielle Signal am differentiellen Eingang der Leitungsanordnung anliegt, gegenseitig nur unwesentlich verdrängen, wobei der zweite Abstand größer als der erste Abstand ist. Hierdurch werden magnetische Verluste und damit die Einfügedämpfung weiter reduziert.

Vorzugsweise verlaufen die dritten und vierten Abschnitte hierbei parallel zueinander, so daß die magnetischen Verluste sinken.

vorzugsweise ist jede Leitungsanordnung derart ausgestaltet, daß die dritten und vierten Abschnitte zusammen eine kürzere Gesamtlänge aufweisen als die ersten und zweiten Abschnitte zusammen.

In einer weiteren Ausgestaltung nimmt der zweite Abstand einen Wert an, der dem zwei- bis sechsfachen, vorzugsweise dem drei- bis fünffachen Wert der Breite der ersten Leiterbahn entspricht.

In einer weiteren Ausgestaltung sind die ersten Leiterbahnen und die zweiten Leiterbahnen jeweils im wesentlichen symmetrisch zu einem Punkt ausgestaltet, der in einem der Kreuzungsbereiche liegt. Eine solche Transmissionsleitung läßt sich einfach entwickeln und realisieren.

In einer alternativen Ausgestaltung sind die ersten Leiterbahnen und die zweiten Leiterbahnen jeweils im wesentlichen symmetrisch zu einer Ebene ausgestaltet, die senkrecht zur Ausbreitungsrichtung des hochfrequenten differentiellen Signals steht. Eine solche Transmissionsleitung läßt sich ebenfalls einfach entwikkeln und realisieren.

Gemäß einer vorteilhaften Ausgestaltung weist die erfindungsgemäße integrierte Schaltung mindestens zwei Metallisierungsebenen auf. Auf diese Weise lassen sich die Kreuzungsbereiche einfach implementieren.

In einer weiteren vorteilhaften Ausgestaltung verlaufen der mindestens eine erste Abschnitt und der mindestens eine zweite Abschnitt in einem Winkel von maximal 45 Grad zueinander. Vorzugsweise beträgt der Winkel maximal 30 Grad. Hierdurch steigt die magnetische Kopplung und damit die Phasenverschiebung und die Güte der Transmissionsleitung besonders stark.

Die Erfindung wird nachfolgend anhand der in den schematischen Figuren der Zeichnung angegebenen Ausführungsbeispiele näher erläutert. Hierbei zeigen
Fig. 1 ein erstes Ausführungsbeispiel der Erfindung (Draufsicht);
Fig. 2 ein zweites Ausführungsbeispiel der Erfindung mit zusätzlichen kapazitiven Elementen (Draufsicht);
Fig. 3 eine Leitungsanordnung für ein drittes Ausführungsbeispiel mit hohem Leitungslänge/Fläche-Verhältnis (Draufsicht);
Fig. 4 eine Leitungsanordnung für ein viertes Ausführungsbeispiel mit hohem Leitungslänge/Fläche-Verhältnis und optimierten Eigenschaften (Draufsicht);
Fig. 5 ein viertes, bevorzugtes Ausführungsbeispiel der Erfindung mit der Leitungsanordnung aus Figur 4 (Draufsicht);
Fig. 6 Leitungseigenschaften verschiedener Ausführungsbeispiele; und
Fig. 7 eine mäanderförmige Transmissionsleitung (Stand der Technik).

In den Figuren sind gleiche und funktionsgleiche Elemente und Signale - sofern nicht anders angegeben - mit denselben Bezugszeichen versehen.

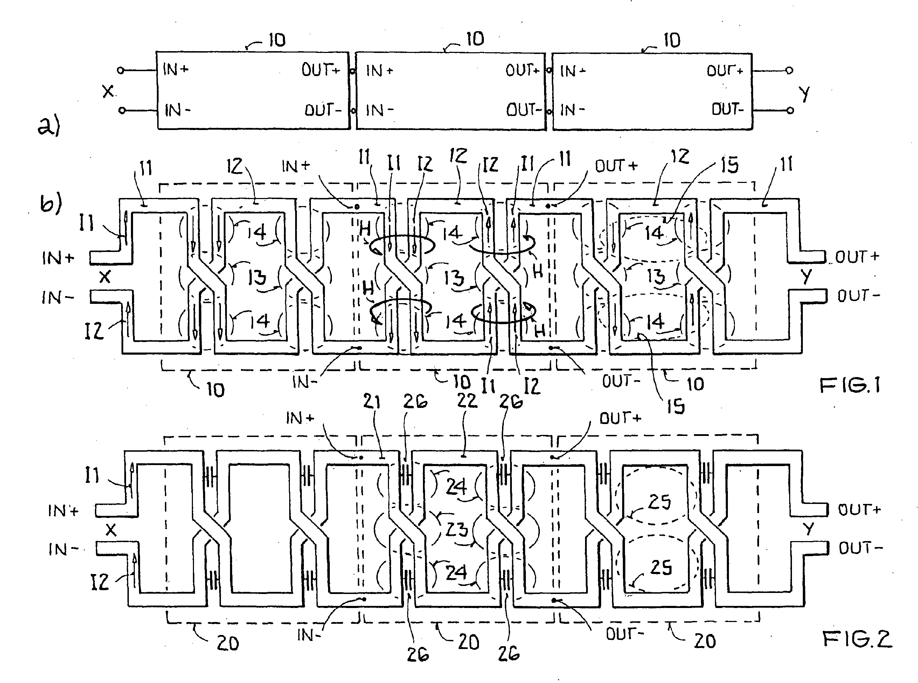

**Figur 1** zeigt in Teil a) ein Blockschaltbild und in Teil b) eine Draufsicht einer integrierbaren Transmissionsleitung zur Übertragung eines hochfrequenten differentiellen Signals x. Die Draufsicht gemäß Fig. 1b entspricht einem Ausschnitt einer horizontalen Schnittebene durch ein erstes Ausführungsbeispiel einer erfindungsgemäßen integrierten Schaltung.

Die in Fig. 1 dargestellte integrierbare Transmissionsleitung umfaßt insgesamt N = 3 in Reihe geschaltete Leitungsanordnungen 10. Jede der Leitungsanordnungen 10 weist hierbei einen differentiellen Eingang IN mit einem ersten Pol IN + und einem zweiten Pol IN- sowie einen differentiellen Ausgang OUT mit einem ersten Pol OUT+ und einem zweiten Pol OUT- auf. Das hochfrequente differentielle Signal x liegt hierbei am differentiellen Eingang IN der in Fig. 1 links dargestellten (eingangsseitigen) Leitungsanordnung 10 an, während das Ausgangssignal γ am differentiellen Ausgang OUT der in Fig. 1 rechts dargestellten (ausgangsseitigen) Leitungsanordnung 10 abgegriffen werden kann.

Wie aus Fig. 1b zu ersehen ist, weist jede Leitungsanordnung 10 eine mit ihrem Eingangspol IN + und ihrem Ausgangspol OUT+ verbundene erste Leiterbahn 11 und eine mit ihrem Eingangspol IN- und ihrem Ausgangspol OUT- verbundene zweite Leiterbahn 12 auf. Die Leiterbahnführung und -ausgestaltung der ersten und zweiten Leiterbahnen ist hierbei in allen Leitungsanordnungen 10 identisch, so daß die N=3 Leitungsanordnungen identisch ausgeführt sind. Stellt man sich z.B. die Leiterbahnen 11 in einer gestreckten geradlinigen Form vor, so ist nachzuvollziehen, daß die geometrische Länge (Bahnlänge) L der so gestreckten Leiterbahnen 11 die größte Dimension der Transmissionsleitung, d.h. die horizontale Ausdehnung der drei Leitungsanordnungen 10 in Signalausbreitungsrichtung, übersteigt. Aufgrund der symmetrischen Anordnung der Leiterbahnen gilt dies auch für die Leiterbahnen 12.

Jede der in Fig. 1b dargestellten Leitungsanordnungen 10 weist zwei Kreuzungsbereiche 13 auf, in denen sich die erste Leiterbahn 11 und die zweite Leiterbahn 12 jeweils kreuzen. Der Kreuzungswinkel liegt hierbei zwischen 45 und 135 Grad, vorzugsweise um 90 Grad (z.B. 70-110 Grad). Um die Leiterbahnen 11, 12 in den Kreuzungsbereichen 13 galvanisch voneinander zu trennen, wird in diesen Bereichen jeweils eine der Leiterbahnen 11 bzw. 12 in einer unteren und die jeweils andere (12 bzw. 11) in einer oberen Metallisierungsebene der integrierten Schaltung geführt, zwischen denen sich ein Isolator z.B. aus Siliziumoxid, Polyimid etc. befindet. Durchkontaktierungen (nicht in Fig. 1b dargestellt) verbinden den in der unteren Metallisierungsebene liegenden Leiterbahnabschnitt (mit unterbrochenen Bahnbegrenzungslinien dargestellt) an seinen Bahnenden mit der entsprechenden, in der oberen Metallisierungsebene verlaufenden Leiterbahn galvanisch.

Wird das hochfrequente differentielle Signal x an den differentiellen Eingang der Transmissionsleitung, d.h. an den differentiellen Eingang IN der eingangsseitigen Leitungsanordnung 10 angelegt, so fließen durch die ersten Leiterbahnen 11 und die zweiten Leiterbahnen 12 die Ströme I1 bzw. I2. Die Richtungen der Ströme I1 und I2 sind in Fig. 1b durch Pfeile innerhalb der Leiterbahnen exemplarisch für einen bestimmten Zeitpunkt dargestellt, in dem der Strom I1 vom Eingangspol IN+ der eingangsseitigen Leitungsanordnung 10 durch die ersten Leiterbahnen 11 zum Ausgangspol OUT+ der ausgangsseitigen Leitungsanordnung 10 und der Strom I2 aufgrund der differentiellen Natur des Signals x vom Ausgangspol OUT- der ausgangsseitigen Leitungsanordnung 10 durch die zweiten Leiterbahnen 12 zum Eingangspol IN- der eingangsseitigen Leitungsanordnung 10 fließt. Zu anderen Zeitpunkten ergeben sich selbstverständlich ggf. umgekehrte Verhältnisse.

Die Ströme I1 und I2 rufen jeweils ein Magnetfeld um die ersten bzw. zweiten Leiterbahnen 11, 12 hervor. In Bereichen, in denen Abschnitte der Leiterbahnen in geringem Abstand voneinander parallel verlaufen, verstärken sich die Magnetfelder im die Leiterbahnabschnitte umgebenden Außenraum gegenseitig (während sie sich im Innenraum zwischen den beiden Leiterbahnen schwächen), sofern die Ströme I1, I2 in die gleiche Richtung, d.h. gleichsinnig fließen. Je kleiner der Abstand der Leiterbahnabschnitte hierbei ist, um so ausgeprägter ist dieser magnetische Verstärkungseffekt im Außenraum um die Leiterbahnen.

Durchfließen die Ströme I1 und I2 direkt benachbarte Leiterbahnabschnitte jedoch in einer gegensinnigen Richtung, d.h. antiparallel, so schwächen sich die Magnetfelder im Außenraum und versuchen im Innenraum, sich zu verdrängen. Dieses Verdrängen führt an sich zu magnetischen Verlusten, aber auch zu einem Verdrängen des Stromflusses im jeweils gegenüberliegenden Leiterbahnabschnitt. Je größer der Abstand dieser Leiterbahnabschnitte hierbei ist, um so schwächer ist dieser Verdrängungseffekt bzw. die magnetischen Verluste. Dieser Effekt tritt schließlich auch bei gegensinnig stromdurchflossenen Abschnitten *derselben* Leiterbahn auf.

Erfindungsgemäß sind die Leitungsanordnungen so ausgestaltet, daß im beide Leiterbahnen umgebenden Außenraum die magnetischen Verstärkungseffekte groß und im Innenraum die magnetischen Verluste klein gehalten werden.

Hierzu werden Leiterbahnabschnitte, die gleichsinnig von den Strömen I1, I2 durchflossen werden, in kleinem Abstand zueinander angeordnet, so daß sich die Magnetfelder in diesen "Mitkopplungsbereichen" der Leitungsanordnung im beide Leiterbahnen umgebenden Außenraum wesentlich verstärken. Vorzugsweise nimmt der Abstand zwischen den nächstliegenden Kanten der mitkoppelnden Leiterbahnabschnitte einen Wert von ca. 50% bis maximal 200% der jeweiligen Leiterbahnbreite an. Typischerweise entspricht dieser Abstand ungefähr einer vollen Leiterbahnbreite (100%).

Wie in Figur 1b dargestellt, weist jede Leitungsanordnung 10 des ersten Ausführungsbeispiels vier Mitkopplungsbereiche 14 auf, in denen die erste Leiterbahn 11 derart in geringem Abstand (der ca. einer vollen Leiterbahnbreite entspricht) parallel zur zweiten Leiterbahn 12 angeordnet ist, daß sich im die Leiterbahnen umgebenden Außenraum die Magnetfelder infolge des gleichsinnigen Stromflusses gegenseitig verstärken. In den vier Mitkopplungsbereichen 14 der in Figur 1b in der Mitte dargestellten Leitungsanordnung 10 sind mit H bezeichnete Feldlinien des resultierenden verstärkten Magnetfeldes eingezeichnet.

Die in den Mitkopplungsbereichen 14 zwischen den Leiterbahnen 11, 12 liegenden Innenräume sind dagegen magnetisch nahezu feldfrei. Diese nahezu feldfreien Räume werden im untenstehend mit Bezug auf Figur 2 näher erläuterten zweiten Ausführungsbeispiel vorteilhaft genutzt.

Gegenläufig (antiparallel) stromdurchflossene Leiterbahnabschnitte werden dagegen in relativ großem Abstand zueinander angeordnet. Unter einem relativ großen Abstand ist hierbei ein Abstand zu verstehen, der größer ist als die vorstehend beschriebenen Abstände zwischen mitkoppelnden Leiterbahnabschnitten. Vorzugsweise nimmt solch ein relativ großer Abstand den doppelten bis sechsfachen, typischerweise den drei- bis fünffachen Wert der Leiterbahnbreite an. In solchen "Gegenkopplungsbereichen" verdrängen sich die Magnetfelder im Innenraum zwischen den gegensinnig stromdurchflossenen Leiterbahnabschnitten aufgrund des relativ großen Abstandes der Leiterbahnabschnitte nur unwesentlich, d.h. es entstehen nur unwesentliche magnetische Verluste. In Fig. 1b sind exemplarisch in der ausgangsseitigen Leitungsanordnung 10 zwei Gegenkopplungsbereiche 15 angedeutet. Der horizontale Abstand der von oben nach unten stromdurchflossenen Leiterbahnabschnitte zu den benachbarten von unten nach oben durchflossenen Abschnitten beträgt in diesem Beispiel ungefähr die fünffache Leiterbahnbreite.

Die Leitungsanordnung 10 ist so ausgestaltet, daß insgesamt ein großer Anteil der in der Leitungsanordnung vorhandenen gesamten Leiterbahnlänge in Mitkopplungsbereiche 14 fällt. Gemäß Figur 1b beträgt dieser Anteil ca. 30%. Weiterhin ist aus Figur 1b zu erkennen, daß die gesamte Bahnlänge der pro Leitungsanordnung 10 in Gegenkopplungsbereiche 15 fallenden Leiterbahnabschnitte diejenige der in Mitkopplungsbereiche 14 fallenden Leiterbahnabschnitte unterschreitet.

Aus Figur 1b ist außerdem zu ersehen, daß die ersten Leiterbahnen 11, aber auch die zweiten Leiterbahnen 12 im wesentlichen punktsymmetrisch zu Punkten ausgestaltet sind, die in der Mitte der Kreuzungsbereiche 13 liegen.

Anstelle von genau N=3 Leitungsanordnungen gemäß Figur 1 können auch andere Werte von N gewählt werden, z.B. N=20. Mindestens sind jedoch zwei Leitungsanordnungen 10 vorzusehen.

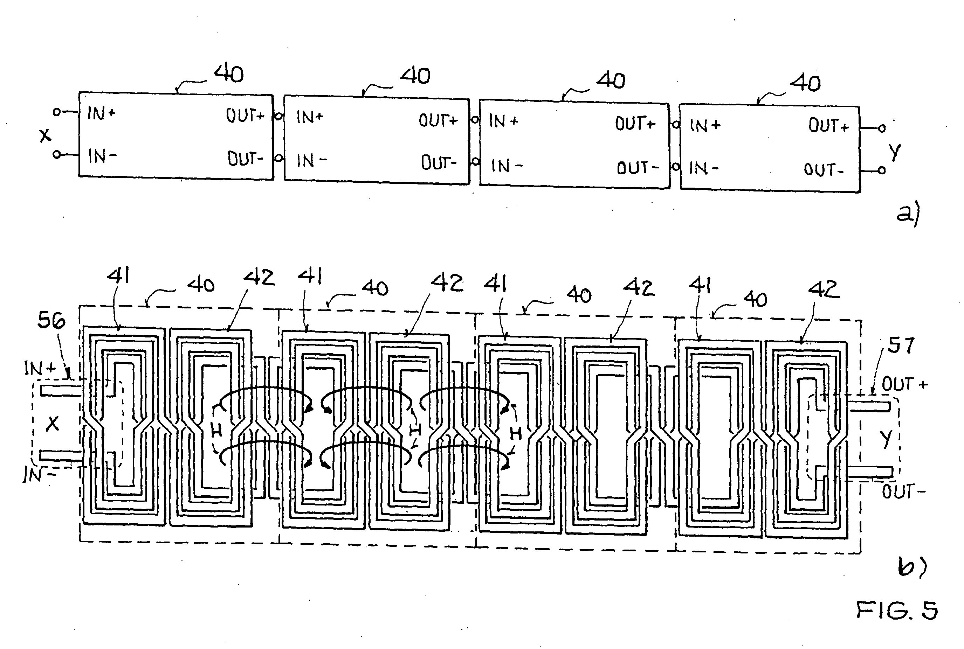

Während z.B. die drei in Figur 1 dargestellten Leitungsanordnungen 10 identisch ausgestaltet sind, kann es beispielsweise zur Vereinfachung der Verbindung der Transmissionsleitung mit anderen Schaltungseinheiten derselben integrierten Schaltung (IC) vorteilhaft sein, die Leiterbahnen im Eingangsbereich der ersten (eingangsseitigen, "linken") Leitungsanordnung und/oder im Ausgangsbereich der letzten (ausgangsseitigen, "rechen") Leitungsanordnung abweichend von den Leiterbahnen der "mittleren" Leitungsanordnung(en) auszugestalten, so daß die Leitungsanordnungen zwar leicht voneinander abweichen, im wesentlichen aber immer noch identisch miteinander sind. Dieser Sachverhalt wird untenstehend mit Bezug auf Figur 5 näher erläutert.

Aufgrund der im wesentlichen identischen Ausgestaltung der Leitungsanordnungen weisen die einzelnen Leitungsanordnungen praktisch identische Eigenschaften wie Wellenwiderstand (Impedanz), Güte (Q-Faktor), Phasendrehung bzw. elektrische Länge auf. Auch die integrierbare Transmissionsleitung aus N in Reihe geschalteten Leitungsanordnungen weist den Wellenwiderstand und die Güte einer einzelnen Leitungsanordnung auf, jedoch die N-fache Phasendrehung bzw. elektrische Länge. Die Anzahl N der benötigten Leitungsanordnungen kann demnach auf einfache Weise aus der insgesamt gewünschten Phasendrehung und der Phasendrehung einer einzelnen Leitungsanordnung bestimmt werden. Diese Zusammenhänge zwischen den Eigenschaften einer einzelnen Leitungsanordnung und denjenigen der gesamten Transmissionsleitung aus N Leitungsanordnungen gelten bei im wesentlichen identisch ausgestalteten Leitungsanordnungen auch für die nachfolgend beschriebenen Ausführungsbeispiele.

Die eingangsseitige und/oder die ausgangsseitige Leitungsanordnung kann schließlich z.B. zur Anpassung des Wellenwiderstandes an die eingangsseitig bzw. ausgangsseitig angeschlossene Schaltungsanordnung jeweils abweichend von der/den mittleren Leitungsanordnung(en) ausgestaltet sein.

Die vorstehend beschriebenen magnetischen Verstärkungseffekte treten auch dann auf, wenn die Leiterbahnabschnitte in den Mitkopplungsbereichen nicht exakt, sondern *im wesentlichen* parallel angeordnet sind bzw. die Ströme diese Leiterbahnabschnitte *im wesentlichen* gleichsinnig durchfließen. Mit "im wesentlichen" ist hierbei gemeint, daß der Öffnungswinkel zwischen den Strömen bzw. den richtungsbehafteten Leiterbahnabschnitten, der im Falle paralleler (und richtungsgleicher) Ströme null Grad beträgt, maximal einen Wert von 45 Grad annimmt. Vorzugsweise nimmt dieser Winkel maximal einen Wert von 30 Grad an. Entsprechendes gilt auch für die Gegenkopplungsbereiche, in denen der Öffnungswinkel, der im Falle antiparalleler Ströme 180 Grad beträgt, minimal einen Wert von 135 Grad annimmt. Vorzugsweise beträgt dieser Winkel mindestens 150 Grad. Auch dieser Sachverhalt trifft ebenfalls auf die nachfolgend beschriebenen Ausführungsbeispiele zu.

**Figur 2** zeigt eine Draufsicht eines zweiten Ausführungsbeispiels mit einer integrierbaren Transmissionsleitung, die ebenfalls N=3 in Serie geschaltete Leitungsanordnungen 20 umfaßt. Da die ersten und zweiten Leiterbahnen 21, 22 identisch zu den Leiterbahnen 11 bzw. 12 des ersten Ausführungsbeispiels angeordnet und ausgestaltet sind, ergeben sich in Figur 2 mit Figur 1 übereinstimmende Kreuzungsbereiche 23, Mitkopplungsbereiche 24 und Gegenkopplungsbereiche 25. Zur Vereinfachung der Darstellung sind die einzelnen Bezugszeichen in Figur 2 nur teilweise angegeben.

Wie mit Bezug auf Figur 1 erläutert, sind die in den Mitkopplungsbereichen 24 zwischen den Leiterbahnen 21, 22 liegenden Räume magnetisch nahezu feldfrei. Diese magnetisch nahezu feldfreien Räume können vorteilhaft zur Unterbringung zusätzlicher integrierter Bauelemente genutzt werden.

Das zweite Ausführungsbeispiel unterscheidet sich vom ersten Ausführungsbeispiel gemäß Figur 1 dadurch, daß in jedem Mitkopplungsbereich 24 ein kapazitives Element 26 zwischen die erste Leiterbahn 21 und die zweite Leiterbahn 22 geschaltet ist, so daß pro Leitungsanordnung 20 insgesamt vier kapazitive Elemente 26 vorgesehen sind. Alternativ können pro Mitkopplungsbereich mehrere parallel geschaltete kapazitive Elemente vorgesehen werden oder in nur zwei (z.B. den in Fig. 2 links dargestellten Mitkopplungsbereichen 24) der vier Mitkopplungsbereiche mindestens je ein kapazitives Element vorgesehen werden.

Durch das Einfügen der kapazitiven Elemente 26 wird der Kapazitätsbelag der Transmissionsleitung erhöht, so daß die Dämpfung der Transmissionsleitung weiter sinkt und die elektrische Länge bzw. die Phasenverschiebung weiter steigt. Außerdem erhöht sich hierdurch die Güte der Transmissionsleitung bei sinkendem Wellenwiderstand (Impedanz).

Bei den kapazitiven Elementen 26 kann es sich um Kondensatoren, z.B. MIM-Kondensatoren (metal insulator metal) hoher Güte, Dioden etc. oder um kapazitive Bauelemente variabler Kapazität, wie z.B. Varaktoren oder CDACs (capacitive digital-to-analog converters) handeln, mit deren Hilfe sich die Eigenschaften der Transmissionsleitung wie der Wellenwiderstand (Impedanz) und die elektrische Länge bzw. die Phasenverschiebung vorteilhaft nach deren Herstellung mittels eines elektrischen Steuersignals einstellen lassen.

Anstelle oder zusätzlich zu den kapazitiven Elementen 26 können in den Mitkopplungsbereichen 24 jeder Leitungsanordnung 20 zwischen der ersten Leiterbahn 21 und der zweiten Leiterbahn 22 insgesamt mindestens zwei verstärkungselemente angeordnet werden. Hierdurch erhält man eine aktive Transmissionsleitung, die vorteilhaft wie ein verteilter Verstärker wirkt. Bei den verstärkungselementen kann es sich vorteilhaft um bi- oder unipolare Transistoren handeln, wobei mindestens ein Transistor an seinem Basis- bzw. Gate-Anschluß mit der ersten Leiterbahn 21 und an seinem Kollektor- bzw. Drain-Anschluß mit der zweiten Leiterbahn 22 verbunden ist und mindestens ein weiterer Transistor an seinem Basis- bzw. Gate-Anschluß mit der zweiten Leiterbahn 22 und an seinem Kollektor- bzw. Drain-Anschluß mit der ersten Leiterbahn 21 verbunden ist. Die Emitter- bzw. Source-Anschlüsse sind hierbei jeweils mit Masse verbunden.

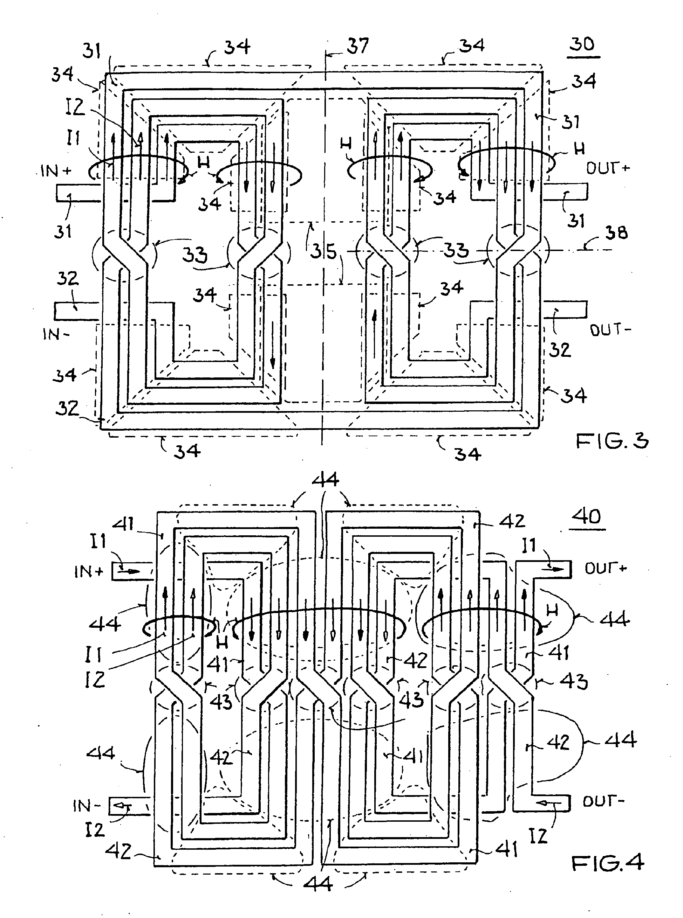

Die **Figuren 3 und 4** zeigen Draufsichten von Leitungsanordnungen 30 bzw. 40 für ein drittes bzw. viertes Ausführungsbeispiel. Diese Ausführungsbeispiele ergeben sich durch N-fache (mindestens zweifache) Hintereinanderschaltung der dargestellten Leitungsanordnung 30 bzw. 40, wobei das bevorzugte vierte Ausführungsbeispiel für den Fall N=4 in Figur 5 dargestellt ist.

Beim dritten und vierten Ausführungsbeispiel sollen auf einer für die Transmissionleitung insgesamt zur Verfügung stehenden Chipfläche gegebener Größe (möglichst) lange Leiterbahnen realisiert werden. In jeder Leitungsanordnung 30 bzw. 40 ist daher ein hohes Leiterbahnlänge/Fläche-Verhältnis erforderlich.

Dies wird erreicht, indem - unter Beachtung der mit Bezug auf Fig. 1 erläuterten Prinzipien und Zielsetzungen - ein großer Anteil der durch die Leitungsanordnung 30 bzw. 40 belegten Fläche durch Leiterbahnen 31, 32 bzw. 41, 42 belegt wird, indem jede Leiterbahn derart schleifenförmig ausgestaltet ist, daß sie pro Leitungsanordnung mindestens zwei Schleifen aufweist, wobei die Schleifen der einen Leiterbahn (z.B. der ersten Leiterbahn 31 bzw. 41) teilweise innerhalb einer Schleife der anderen Leiterbahn (z.B. der zweiten Leiterbahn 32 bzw. 42) verlaufen und teilweise eine Schleife der anderen Leiterbahn (z.B. 32 bzw. 42) umfassen. Die Leitungsanordnung 30 bzw. 40 ist hierbei derart ausgestaltet, daß benachbarte Leiterbahnabschnitte dieser ineinander liegenden Leiterbahnschleifen gleichsinnig von den Strömen I1 und I2 durchflossen werden.

Gemäß **Figur 3** ist die erste Leiterbahn 31 derart ausgebildet, daß sie ausgehend vom Eingangspol IN+ in der linken Hälfte der Leitungsanordnung 30 eine erste Schleife im Uhrzeigersinn bildet, dann oben in der Figur in die rechte Hälfte der Leitungsanordnung 30 geführt wird und dort eine zweite Schleife im Uhrzeigersinn bildet, die mit dem Ausgangspol OUT+ verbunden ist. Die zweite Leiterbahn 32 ist derart ausgebildet, daß sie ausgehend vom Ausgangspol OUT- in der rechten Hälfte der Leitungsanordnung 30 eine dritte Schleife im Uhrzeigersinn bildet, dann unten in der Figur in die linke Hälfte überführt wird, und dort eine vierte Schleife im Uhrzeigersinn bildet, die mit dem Eingangspol IN- verbunden ist. Mit Hilfe von insgesamt vier Kreuzungsbereichen 33 wird erreicht, daß die erste Schleife hierbei teilweise innerhalb und teilweilse außerhalb der vierten Schleife liegt und die zweite Schleife teilweise innerhalb und teilweise außerhalb der dritten schleife angeordnet ist.

Zu jedem Zeitpunkt durchfließen die Ströme I1, I2 die in den Schleifenbereichen liegenden benachbarten Leiterbahnabschnitte gleichsinnig, d.h. in einer einheitlichen Richtung. Im Falle der eingezeichneten Stromrichtungen werden beispielsweise alle vier Schleifen im Uhrzeigersinn durchflossen. Insgesamt können 12 Mitkopplungsbereiche 34 identifiziert werden, in denen sich aufgrund von gleichsinnig stromdurchflossenen Leiterbahnabschnitten die Magnetfelder im Außenraum um diese Leiterbahnabschnitte gegenseitig verstärken.

Die beiden Leiterbahnen 31, 32 sind jeweils im wesentlichen symmetrisch zu einer Ebene ausgestaltet, die senkrecht zur Ausbreitungsrichtung des differentiellen Signals x (von links nach rechts in Figur 3) steht und in Figur 3 durch ihre Schnittlinie 37 mit der Zeichenebene dargestellt ist.

Rechts und links der Schnittlinie 37 weist die Leitungsanordnung 30 gegensinnig (antiparallel) stromdurchflossene Leiterbahnabschnitte parallel zu dieser Linie 37 auf. In diesen Gegenkopplungsbereichen 35 entstehen magnetische Verluste, die sich, wie in Figur 3 gezeigt, z.B. durch einen relativ großen horizontalen Abstand der Leiterbahnabschnitte im wesentlichen vermeiden lassen. Die Magnetfelder, die durch die jeweiligen Ströme hervorgerufen werden, schwächen sich in den Außenräumen und verdrängen sich in den Innenräumen dieser Leiterbahnabschnitte dann nur unwesentlich. Die in die Gegenkopplungsbereiche 35 fallenden Leiterbahnabschnitte werden also derart in großem Abstand zueinander angeordnet, daß sich im Innenraum zwischen den Leiterbahnabschnitten die Magnetfelder, die durch die Ströme hervorgerufen werden, die in den Leiterbahnabschnitten fließen, wenn das hochfrequente differentielle Signal x am differentiellen Eingang IN der Leitungsanordnung anliegt, gegenseitig nur unwesentlich verdrängen.

Hinsichtlich der vorteilhaften Abstände zwischen direkt benachbarten Leiterbahnabschnitten in den Mitkopplungs- bzw. Gegenkopplungsbereichen wird auf die vorstehenden diesbezüglichen Ausführungen mit Bezug auf Figur 1 verwiesen. Gemäß Figur 3 entsprechen die Abstände in den Mitkopplungsbereichen 34 ungefähr einer halben Leiterbahnbreite, diejenigen in den Gegenkopplungsbereichen 35 ungefähr dem Fünffachen einer Leiterbahnbreite.

Gemäß Figur 3 wird ein hoher Anteil, nämlich ca. 70-80% der gesamten Leiterbahnlänge in Mitkopplungsbereichen 34 geführt. Weiterhin ist aus Figur 3 zu erkennen, daß die gesamte Bahnlänge der pro Leitungsanordnung 30 in Gegenkopplungsbereiche 35 fallenden Leiterbahnabschnitte diejenige der in Mitkopplungsbereiche 34 fallenden Leiterbahnabschnitte deutlich unterschreitet.

Durch die schleifenförmige Ausgestaltung der Leiterbahnen 31, 32 wird ein großer Anteil, im Falle der Figur 3 ca. 1/3 der von der Leitungsanordnung 30 insgesamt belegten Fläche durch die erste oder zweite Leiterbahn belegt, so daß sich vorteilhaft ein hohes Leiterbahnlänge/Fläche-Verhältnis ergibt.

Analog zum zweiten Ausführungsbeispiel gemäß Figur 2 können auch im dritten Ausführungsbeispiel in den Mitkopplungsbereichen 34 jeder Leitungsanordnung 30 mindestens zwei kapazitive Elemente und/oder mindestens zwei verstärkungselemente (jeweils mindestens eines in der oberen Hälfte und mindestens eines in der unteren Hälfte) zwischen die erste und die zweite Leiterbahn geschaltet werden. So kann beispielsweise in der linken und/oder der rechten Hälfte der Leitungsanordnung zwischen dem in Fig. 3 obersten horizontalen Leiterbahnabschnitt und dem darunter gezeichneten horizontalen Abschnitt sowie zwischen dem untersten und dem darüber gezeichneten horizontalen Abschnitt je ein Kondensator, Varaktor und/oder Transistor vorgesehen werden.

Anstelle von nur einer Schleife pro Hälfte der Leitungsanordnung kann jede Leiterbahn auch mehrere Schleifen pro Hälfte der Leitungsanordnung bilden. Hierdurch lassen sich auf einer gegebenen Fläche noch größere Leiterbahnlängen integrieren, allerdings steigt damit die Zahl der erforderlichen Metallisierungsebenen entsprechend.

Weiterhin können die Schleifen anstelle der eckigen Ausprägung gemäß Figur 3 auch mit "abgerundeten Ecken", oktaedrisch, oval oder rundlich ausgeführt sein.

Zum parallelen bzw. im wesentlichen parallelen Verlauf von Leiterbahnabschnitten wird auf die vorstehenden Erläuterungen zu Figur 1 verwiesen.

**Figur 4** zeigt eine Draufsicht einer Leitungsanordnung 40 für ein viertes, bevorzugtes Ausführungsbeispiel, bei dem mit geringen magnetischen Verlusten ein sehr hohes Leiterbahnlänge/Fläche-Verhältnis erzielt werden soll.

Dies wird erreicht, indem anschaulich die rechte Hälfte der Leitungsanordnung 30 aus Figur 3 um 180 Grad um die in Figur 3 eingezeichnete Achse 38 der Transmissionsleitung gedreht wird, die Verbindungspunkte zur linken Hälfte und die Ausgangspole OUT+, OUT- jedoch in ihrer Position erhalten bleiben. Hierdurch entstehen zwei zusätzliche Kreuzungsbereiche 43 in der Mitte der Leitungsanordnung 40 sowie nahe den Ausgangspolen OUT+ und OUT-.

Gemäß Figur 4 ist die erste Leiterbahn 41 derart ausgebildet, daß sie ausgehend vom Eingangspol IN + in der linken Hälfte der Leitungsanordnung 40 eine erste Schleife im Uhrzeigersinn bildet, dann in der Figur von oben über den zusätzlichen mittleren Kreuzungsbereich 43 nach unten in die rechte Hälfte geführt wird und dort eine zweite Schleife im Gegenuhrzeigersinn bildet, die über den zusätzlichen ausgangsseitigen Kreuzungsbereich 43 mit dem Ausgangspol OUT+ verbunden ist. Die zweite Leiterbahn 42 ist derart ausgebildet, daß sie ausgehend vom Ausgangspol OUT- nach Durchlaufen des ausgangsseitigen Kreuzungsbereichs 43 in der rechten Hälfte der Leitungsanordnung 40 eine dritte Schleife im Gegenuhrzeigersinn bildet, dann in der Figur von oben über den zusätzlichen mittleren Kreuzungsbereich 43 nach unten in die linke Hälfte geführt wird, und dort eine vierte Schleife im Uhrzeigersinn bildet, die mit dem Eingangspol INverbunden ist. Analog zu Figur 3 wird hierbei mit Hilfe von vier Kreuzungsbereichen 43 erreicht, daß die erste Schleife teilweise innerhalb und teilweilse außerhalb der vierten Schleife liegt und die zweite Schleife teilweise innerhalb und teilweise außerhalb der dritten Schleife angeordnet ist.

Zu jedem Zeitpunkt durchfließen die Ströme I1, I2 die in den Schleifenbereichen liegenden benachbarten Leiterbahnabschnitte gleichsinnig, d.h. in einer einheitlichen Richtung. Im Falle der durch die eingezeichneten Pfeile gekennzeichneten Stromrichtungen werden beispielsweise die erste und vierte Schleife in der linken Hälfte der Leitungsanordnung 40 im Uhrzeigersinn und die zweite und dritte Schleife in der rechten Hälfte im Gegenuhrzeigersinn durchflossen. Durch die zu allen Zeitpunkten unterschiedliche Drehrichtungen (Uhrzeiger- bzw. Gegenuhrzeigersinn) in der linken bzw. rechten Hälfte der Leitungsanordnung 40 fließen nunmehr auch an der Trennlinie der beiden Hälften die Ströme gleichsinnig.

Insgesamt können 10 Mitkopplungsbereiche 44 identifiziert werden, in denen sich aufgrund von gleichsinnig stromdurchflossenen Leiterbahnabschnitten die Magnetfelder im Außenraum um diese Leiterbahnabschnitte gegenseitig verstärken. Die beiden großen zentralen Mitkopplungsbereiche 44, die nunmehr jeweils sechs gleichsinnig stromdurchflossene parallele Leiterbahnabschnitte umfassen, treten an die Stelle der vier kleineren zentralen Mitkopplungsbereiche 34 (aus je zwei Leiterbahnabschnitten) und die beiden Gegenkopplungsbereiche 35 aus Figur 3. Auch bei einer eingangs- und/oder ausgangsseitigen Fortsetzung der Leitungsanordnung 40 durch weitere Leitungsanordnungen 40 vergrößern sich die eingangs- bzw. ausgangsseitigen Mitkopplungsbereiche 44 von zwei bzw. vier auf sechs parallele Leiterbahnabschnitte; Gegenkopplungsbereiche entstehen hierbei nicht. Die durch die 180-Grad-Drehung der rechten Hälfte der Leitungsanordnung 30 aus Figur 3 zusätzlich entstandenen Leiterbahnabschnitte fallen daher praktisch vollständig in Mitkopplungs- oder Kreuzungsbereiche, die zentralen Gegenkopplungsbereiche 35 aus Figur 3 sowie die Gegenkopplungsbereiche zwischen identischen Leitungsanordnungen 30 entfallen dagegen in Figur 4.

Auf diese Weise wird ein sehr hoher Anteil, nämlich ca. 80-90% der gesamten Leiterbahnlänge in Mitkopplungsbereichen 44 geführt. Außerdem wird ein großer Anteil, im Falle der Figur 4 ca. 40-50% der von der Leitungsanordnung 40 insgesamt belegten Fläche durch die erste oder zweite Leiterbahn 41, 42 belegt, so daß sich vorteilhaft ein sehr hohes Leiterbahnlänge/Fläche-Verhältnis ergibt.

Hinsichtlich der vorteilhaften Abstände zwischen direkt benachbarten Leiterbahnabschnitten in den Mitkopplungsbereichen wird auf die vorstehenden diesbezüglichen Ausführungen zu Figur 1 verwiesen. Gemäß Figur 4 entsprechen die Abstände in den Mitkopplungsbereichen 44 ungefähr einer halben Leiterbahnbreite.

Analog zum zweiten und dritten Ausführungsbeispiel können auch im vierten Ausführungsbeispiel in den Mitkopplungsbereichen 44 jeder Leitungsanordnung 40 mindestens zwei kapazitive Elemente und/oder mindestens zwei Verstärkungselemente (jeweils mindestens eines in der oberen Hälfte und mindestens eines in der unteren Hälfte) zwischen die erste und die zweite Leiterbahn geschaltet werden. Im Vergleich zum dritten Ausführungsbeispiel können solche Elemente nunmehr auch auf der Trennlinie zwischen der rechten und der linken Hälfte der Leitungsanordnung 40 oder an den Berührungslinien zweier in Reihe geschalteter Leitungsanordnungen 40 vorgesehen werden (jeweils in Mitkopplungsbereichen).

Analog zum dritten Ausführungsbeispiel können auch im vierten Ausführungsbeispiel mehrere Schleifen pro Hälfte der Leitungsanordnung vorgesehen werden und die Schleifen eckig, abgerundet, rundlich etc. ausgeführt werden.

**Figur 5** zeigt schließlich in Teil a) ein Blockschaltbild und in Teil b) eine Draufsicht eines bevorzugten vierten Ausführungsbeispiels mit einer integrierbaren Transmissionsleitung, die N=4 in Serie geschaltete Leitungsanordnungen 40 gemäß Figur 4 umfaßt. Hierbei entsprechen die beiden mittleren Leitungsanordnungen exakt der Darstellung gemäß Figur 4, während die Leiterbahnführung im Eingangsbereich 56 der eingangsseitigen Leitungsanordnung und im Ausgangsbereich 57 der ausgangsseitigen Leitungsanordnung leicht modifiziert wurde, um z.B. die Transmissionsleitung einfacher mit anderen Schaltungseinheiten derselben integrierten Schaltung (IC) verbinden zu können.

Anhand der exemplarisch eingezeichneten Feldlinien (H) ist zu erkennen, daß alle Mitkopplungsbereiche, die sich direkt oberhalb und unterhalb der Kreuzungsbereiche anschließen, nunmehr sechs gleichsinnig stromdurchflossene Leiterbahnabschnitte aufweisen, deren Magnetfelder sich im Außenraum um diese Abschnitte wesentlich verstärken. Das vierte Ausführungsbeispiel ermöglicht es so, bei sehr kleinen magnetischen Verlusten sehr lange Leiterbahnen auf einer kleinen Fläche zu integrieren.

Aus Figur 5 ist zu ersehen, daß die ersten Leiterbahnen 41, aber auch die zweiten Leiterbahnen 42 im wesentlichen punktsymmetrisch zu Punkten ausgestaltet sind, die in der Mitte des jeweils zentralen von drei aufeinanderfolgenden Kreuzungsbereichen 43 liegen. Leichte Abweichungen von dieser Symmetrie ergeben sich insbesondere im Eingangsbereich 56 und im Ausgangsbereich 57.

Anstelle von genau N=4 Leitungsanordnungen gemäß Figur 5 können auch andere Werte von N gewählt werden. Mindestens sind jedoch zwei Leitungsanordnungen vorzusehen.

In allen Leitungsanordnungen 40 aus Figur 5 kann schließlich auf den ausgangsseitigen Kreuzungsbereich sowie die sich daran direkt anschließenden vertikalen Leiterbahnabschnitte verzichtet werden. Bei ungeraden Werten von N hat dies zur Folge, daß der Ausgangspol OUT+ im Gegensatz zu Figur 5 rechts unten und der Ausgangspol OUT- rechts oben angeordnet ist, während sich bei geraden Werten von N im Vergleich zu Figur 5 unveränderte Verhältnisse ergeben.

**Figur 6** zeigt schematisch verschiedene Leitungseigenschaften des ersten, zweiten und vierten Ausführungsbeispiels. Zum vergleich sind auch die Eigenschaften einer mäanderförmigen Leitung dargestellt. In allen Fällen weist die durch die jeweilige Transmissionsleitung beanspruchte Fläche dieselbe Größe auf. Die mit A-D bezeichneten Verläufe beziehen sich wie folgt auf die einzelnen Transmissionsleitungen:
- A: mäanderförmige Transmissionsleitung gemäß Fig. 7 (identisch fortgesetzt),
- B: erstes Ausführungsbeispiel gemäß Figur 1,
- C: zweites Ausführungsbeispiel gemäß Figur 2 mit MIM-Kondensatoren, und
- D: viertes Ausführungsbeispiel gemäß Figur 5, jedoch mit N=3.

In Figur 6a ist die durch die jeweilige Transmissionsleitung verursachte Phasenverschiebung Δφ des Signals x bzw. die hierzu proportionale elektrische Länge Lₑₗ der jeweiligen Transmissionsleitung über der Frequenz f (in GHz) dargestellt. Figur 6b zeigt den Q-Faktor als Maß für die Güte der jeweiligen Transmissionsleitung über der Frequenz f.

Wie aus Figur 6a zu erkennen ist, weist die mäanderförmige Transmissionsleitung (A) bei allen betrachteten Frequenzwerten den jeweils kleinsten Wert der Phasenverschiebung bzw. der elektrische Länge auf. Beim ersten Ausführungsbeispiel (B) steigen die Werte der Phasenverschiebung bei jedem vorgegebenen Frequenzwert im betrachteten Frequenzbereich auf ungefähr den jeweils doppelten Wert, während sich im Falle des zweiten Ausführungsbeispiels (C) die Phasenverschiebung fast versechsfacht. Aus dem Kurvenverlauf D für das vierte Ausführungsbeispiel ist zu erkennen, daß die Werte der Phasenverschiebung bei jedem Frequenzwert auf ca. den jeweils 12-fachen Wert steigen.

Aus Figur 6b ist schließlich zu ersehen, daß die mäanderförmige Transmissionsleitung (A) bei Frequenzen oberhalb von 1 GHz jeweils den niedrigsten Wert der Güte und damit die höchste Einfügedämpfung aufweist. Demgegenüber erhöht sich z.B. bei f=10 GHz im Falle des ersten Ausführungsbeispiels (B) der Wert des Q-Faktors um fast 60%, während er beim zweiten Ausführungsbeispiel (C) auf fast den sechsfachen Wert und beim vierten Ausführungsbeispiel (D) auf ungefähr den dreifachen Wert im vergleich zur mäanderförmigen Transmissionsleitung (A) ansteigt. Die Einfügedämpfung des zweiten Ausführungsbeispiels (C) bzw. des vierten Ausführungsbeispiels (D) reduziert sich also auf ungefähr 1/6 bzw. 1/3 der Werte der mäanderförmigen Leitung (A).

Die anhand von Ausführungsbeispielen vorstehend beschriebene Transmissionsleitung kann in unterschiedlichsten Anwendungen in Resonator-, Filter-, Anpaß- (Matching), Impedanztransformations-, Verstärker-Schaltungen etc. vorteilhaft eingesetzt werden.

Die Transmissionsleitung ist erfindungsgemäß Bestandteil einer integrierten Schaltung, die z.B. als monolithisch integrierte Schaltung (z.B. application specific integrated circuit, ASIC, oder application specific standard product, ASSP), als Hybridschaltung (Dünn- bzw. Dickschichttechnologie) oder als Multilayer-Keramik-Schaltungs-anordnung ausgebildet ist.

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf die gezeigten Leitungslängen, -breiten oder -abstände, noch auf die angegebenen exemplarischen Werte von N, die genannten beispielhaften Anzahlen von Kreuzungs-, Mitkopplungs- und Gegenkopplungsbereichen bzw. die Anzahl der darin jeweils enthaltenen Leiterbahnabschnitte etc. beschränkt. Anstelle der in den Figuren gezeigten eckigen Ausbildung der Leiterbahnen können diese auch oktaedrisch, rundlich, oval etc. ausgestaltet sein. Auch ist die Erfindung nicht auf die gezeigten Anzahlen ineinanderliegender Leiterbahnschleifen oder die angegebenen Anzahlen von Metallisierungsebenen beschränkt.

### Bezugszeichenliste

- 10: Leitungsanordnung
- 11: erste Leiterbahn
- 12: zweite Leiterbahn
- 13: Kreuzungsbereiche
- 14: Mitkopplungsbereiche
- 15: Gegenkopplungsbereiche
- 20: Leitungsanordnung
- 21: erste Leiterbahn
- 22: zweite Leiterbahn
- 23: Kreuzungsbereiche
- 24: Mitkopplungsbereiche
- 25: Gegenkopplungsbereiche
- 26: kapazitives Element
- 30: Leitungsanordnung
- 31: erste Leiterbahn
- 32: zweite Leiterbahn
- 33: Kreuzungsbereiche
- 34: Mitkopplungsbereiche
- 35: Gegenkopplungsbereiche
- 37: Schnittlinie
- 38: Spiegelungsachse
- 40: Leitungsanordnung
- 41: erste Leiterbahn
- 42: zweite Leiterbahn
- 43: Kreuzungsbereiche
- 44: Mitkopplungsbereiche
- 56: abweichende eingangsseitige Leitungsführung
- 57: abweichende ausgangsseitige Leitungsführung

- ASIC: application specific integrated circuit
- ASSP: application specific standard product
- CDAC: capacitive digital-to-analog converter
- GHZ: Giga-Hertz
- IC: integrated circuit
- IN: differentieller Eingang der Leitungsanordnung
- IN+: erster Pol des differentiellen Eingangs
- IN-: zweiter Pol des differentiellen Eingangs
- MIM: metal insulator metal
- OUT: differentieller Ausgang der Leitungsanordnung
- OUT +: erster Pol des differentiellen Ausgangs
- OUT-: zweiter Pol des differentiellen Ausgangs

- A: mäanderförmige Transmissionsleitung gemäß Figur 7
- B: erstes Ausführungsbeispiel gemäß Figur 1
- C: zweites Ausführungsbeispiel gemäß Figur 2
- D: viertes Ausführungsbeispiel gemäß Figur 5
- f: Frequenz
- H: magnetische Feldstärke; Feldlinien des Magnetfeldes
- I1, I2: in der ersten bzw. zweiten Leiterbahn fließender Strom
- L: geometrische Länge einer (gestreckten) Leiterbahn
- Lₑₗ: elektrische Länge
- N: Anzahl der Leitungsanordnungen
- Q: Güte
- x: hochfrequentes differentielles Signal

- Δφ: Phasenverschiebung

## Patentansprüche

1. Integrierte Schaltung mit mindestens einer integrierten Transmissionsleitung zur Übertragung eines hochfrequenten differentiellen Signals (x), beinhaltend:
a) eine Anzahl (N) von mindestens zwei in Reihe geschalteten Leitungsanordnungen (10; 20; 30; 40), die jeweils einen differentiellen Eingang (IN), einen differentiellen Ausgang (OUT), eine mit einem ersten Pol (IN +) des differentiellen Eingangs und einem ersten Pol (OUT +) des differentiellen Ausgangs verbundene erste Leiterbahn (11; 21; 31; 41) und eine mit einem zweiten Pol (IN-) des differentiellen Eingangs und einem zweiten Pol (OUT-) des differentiellen Ausgangs verbundene zweite Leiterbahn (12; 22; 32; 42) aufweisen,
b) jede Leitungsanordnung mindestens zwei Kreuzungsbereiche (13; 23; 33; 43) aufweist, in denen sich die erste und die zweite Leiterbahn kreuzen,
**dadurch gekennzeichnet, daß**
c) jede Leitungsanordnung mindestens vier Mitkopplungsbereiche (14; 24; 34; 44) aufweist, in denen jeweils mindestens ein erster Abschnitt der ersten Leiterbahn (11; 21; 31; 41) derart in einem kleinen ersten Abstand zu mindestens einem zweiten Abschnitt der zweiten Leiterbahn (12; 22; 32; 42) angeordnet ist, daß sich im die ersten und zweiten Abschnitte umgebenden Außenraum die Magnetfelder, die durch die Ströme (I1, I2) hervorgerufen werden, die in den ersten und zweiten Abschnitten fließen, wenn das hochfrequente differentielle Signal (x) am differentiellen Eingang (IN) der Leitungsanordnung anliegt, gegenseitig verstärken.

2. Schaltung nach Anspruch 1, **dadurch gekennzeichnet, daß** der mindestens eine erste Abschnitt und der mindestens eine zweite Abschnitt parallel oder im wesentlichen parallel zueinander verlaufen.

3. Schaltung nach einem der vorhergehenden Ansprüche, **dadurch gekennzeichnet, daß** die Leitungsanordnungen (10; 20; 30; 40) im wesentlichen identisch sind.

4. Schaltung nach einem der vorhergehenden Ansprüche, **dadurch gekennzeichnet, daß** jede Leitungsanordnung derart ausgestaltet ist, daß die ersten und zweiten Abschnitte zusammen eine Gesamtlänge aufweisen, die einem hohen Anteil, vorzugsweise mindestens einem Drittel, der Gesamtlänge der ersten und der zweiten Leiterbahn dieser Leitungsanordnung entspricht.

5. Schaltung nach einem der vorhergehenden Ansprüche, **dadurch gekennzeichnet, daß** der erste Abstand einen Wert annimmt, der 50% bis 200%, vorzugsweise 100% der Breite der ersten Leiterbahn entspricht.

6. Schaltung nach einem der vorhergehenden Ansprüche, **dadurch gekennzeichnet, daß** in den Mitkopplungsbereichen (14; 24; 34; 44) jeder Leitungsanordnung zwischen der ersten Leiterbahn (11; 21; 31; 41) und der zweiten Leiterbahn (12; 22; 32; 42) insgesamt mindestens zwei kapazitive Elemente (26) angeordnet sind.

7. Schaltung nach Anspruch 6, **dadurch gekennzeichnet, daß** die mindestens zwei kapazitiven Elemente (26) mindestens einen Kondensator, vorzugsweise einen MIM-Kondensator aufweisen.

8. Schaltung nach Anspruch 6 oder 7, **dadurch gekennzeichnet, daß** die mindestens zwei kapazitiven Elemente (26) mindestens ein Element variabler Kapazität, vorzugsweise einen Varaktor oder einen kapazitiven Digital/AnalogWandler (CDAC), aufweisen.

9. Schaltung nach einem der vorhergehenden Ansprüche, **dadurch gekennzeichnet, daß** in den Mitkopplungsbereichen (14; 24; 34; 44) jeder Leitungsanordnung zwischen der ersten Leiterbahn (11; 21; 31; 41) und der zweiten Leiterbahn (12; 22; 32; 42) insgesamt mindestens zwei Verstärkungselemente, vorzugsweise Transistoren, angeordnet sind.

10. Schaltung nach einem der vorhergehenden Ansprüche, **dadurch gekennzeichnet, daß** jede Leitungsanordnung derart ausgestaltet ist, daß insgesamt ein großer Anteil, vorzugsweise mindestens 1/3, der von der Leitungsanordnung insgesamt belegten Fläche durch die erste oder die zweite Leiterbahn belegt wird.

11. Schaltung nach einem der vorhergehenden Ansprüche, **dadurch gekennzeichnet, daß** jede Leitungsanordnung derart ausgestaltet ist, daß die erste Leiterbahn (31; 41) und die zweite Leiterbahn (32; 42) jeweils mindestens zwei Schleifen bilden und die Schleifen der ersten Leiterbahn teilweise innerhalb der Schleifen der zweiten Leiterbahn liegen und diese teilweise umfassen.

12. Schaltung nach einem der vorhergehenden Ansprüche, **dadurch gekennzeichnet, daß** jede Leitungsanordnung derart ausgestaltet ist, daß sich die Ströme, die jeweils in direkt benachbarten Leiterbahnabschnitten fließen, wenn das hochfrequente differentielle Signal (x) am differentiellen Eingang (IN) der Leitungsanordnung anliegt, in keinem der direkt benachbarten Leiterbahnabschnitte gegenseitig wesentlich verdrängen.

13. Schaltung nach einem der vorhergehenden Ansprüche, **dadurch gekennzeichnet, daß** jede Leitungsanordnung Gegenkopplungsbereiche (15; 25; 35) aufweist, in denen jeweils ein dritter Abschnitt der ersten oder zweiten Leiterbahn derart in einem größeren zweiten Abstand zu einem direkt benachbarten vierten Abschnitt der ersten oder zweiten Leiterbahn angeordnet ist, daß sich im Innenraum zwischen den dritten und vierten Abschnitten die Magnetfelder, die durch die Ströme hervorgerufen werden, die in den dritten und vierten Abschnitten fließen, wenn das hochfrequente differentielle Signal (x) am differentiellen Eingang (IN) der Leitungsanordnung anliegt, gegenseitig nur unwesentlich verdrängen, wobei der zweite Abstand größer als der erste Abstand ist.

14. Schaltung nach Anspruch 13, **dadurch gekennzeichnet, daß** der dritte und der vierte Abschnitt parallel zueinander verlaufen.

15. Schaltung nach Anspruch 13 oder 14, **dadurch gekennzeichnet, daß** jede Leitungsanordnung derart ausgestaltet ist, daß die dritten und vierten Abschnitte zusammen eine kürzere Gesamtlänge aufweisen als die ersten und zweiten Abschnitte zusammen.

16. Schaltung nach einem der Ansprüche 13 bis 15, **dadurch gekennzeichnet, daß** der zweite Abstand einen Wert annimmt, der dem zwei- bis sechsfachen, vorzugsweise dem drei- bis fünffachen Wert der Breite der ersten Leiterbahn entspricht.

17. Schaltung nach einem der vorhergehenden Ansprüche, **dadurch gekennzeichnet, daß** die ersten Leiterbahnen (11; 21; 41) und die zweiten Leiterbahnen (12; 22; 42) jeweils im wesentlichen symmetrisch zu einem Punkt ausgestaltet sind, der in einem der Kreuzungsbereiche (13; 23; 43) liegt.

18. Schaltung nach einem der Ansprüche 1 bis 16, **dadurch gekennzeichnet, daß** die ersten Leiterbahnen (31) und die zweiten Leiterbahnen (32) jeweils im wesentlichen symmetrisch zu einer Ebene (37) ausgestaltet sind, die senkrecht zur Ausbreitungsrichtung des hochfrequenten differentiellen Signals (x) steht.

19. Schaltung nach einem der vorhergehenden Ansprüche, **dadurch gekennzeichnet, daß** die Schaltung mindestens zwei Metallisierungsebenen aufweist.

20. Schaltung nach einem der vorhergehenden Ansprüche, **dadurch gekennzeichnet, daß** der mindestens eine erste Abschnitt und der mindestens eine zweite Abschnitt gleichsinnig oder im wesentlichen gleichsinnig von Strömen durchflossen werden, wenn das hochfrequente differentielle Signal (x) am differentiellen Eingang (IN) der Leitungsanordnung anliegt.

21. Schaltung nach einem der vorhergehenden Ansprüche, **dadurch gekennzeichnet, daß** der mindestens eine erste Abschnitt und der mindestens eine zweite Abschnitt in einem Winkel von maximal 45 Grad zueinander verlaufen.

22. Schaltung nach einem der vorhergehenden Ansprüche, **dadurch gekennzeichnet, daß** der mindestens eine erste Abschnitt und der mindestens eine zweite Abschnitt in einem Winkel von maximal 30 Grad zueinander verlaufen.

## Claims

1. Integrated circuit with at least one integrated transmission line for transmission of a high-frequency differential signal (x), comprising:
a) a number (N) of at least two line arrangements (10; 20; 30; 40), which are connected in series and which each have a differential input (IN), a differential output (OUT), a first conductor track (11; 21; 31; 41) connected with a first pole (IN+) of the differential input and a first pole (OUT+) of the differential output and a second conductor track (12; 22; 32; 42) connected with a second pole (IN-) of the differential input and a second pole (OUT-) of the differential output,
b) each line arrangement has at least two crossing regions (13; 23; 33; 43) in which the first and second conductor tracks cross,
**characterised in that**
c) each line arrangement has at least four coupling regions (14; 24; 34; 44) in which in each instance at least one first section of the first conductor track (11; 21; 31; 41) is arranged at a small first spacing from at least one second section of the second conductor track (12; 22; 32; 42) in such a manner that in the outside space surrounding the first and second sections the magnetic fields produced by the currents (I1, I2) flowing in the first and second sections mutually amplify one another when the high-frequency differential signal (x) is present at the differential input (IN) of the conductor arrangement.

2. Circuit according to claim 1, **characterised in that** the at least one first section and the at least one second section run parallelly or substantially parallelly to one another.

3. Circuit according to one of the preceding claims, **characterised in that** the line arrangements (10; 20; 30; 40) are substantially identical.

4. Circuit according to any one of the preceding claims, **characterised in that** each line arrangement is designed in such a manner that the first and second sections together have a total length which corresponds to a high proportion, preferably at least a third, of the total length of the first and second conductor tracks of this line arrangement.

5. Circuit according to any one of the preceding claims, **characterised in that** the first spacing has a value corresponding with 50 to 200%, preferably 100%, of the width of the first conductor track.

6. Circuit according to any one of the preceding claims, **characterised in that** in total at least two capacitive elements (26) are arranged in the coupling regions (14; 24; 34; 44) of each line arrangement between the first conductor track (11; 21; 31; 41) and the second conductor track (12; 22; 32; 42).

7. Circuit according to claim 6, **characterised in that** the at least two capacitive elements (26) comprise at least one capacitor, preferably an MIM capacitor.

8. Circuit according to claim 6 or 7, **characterised in that** the at least two capative elements (26) comprise at least one element of variable capacitance, preferably a varactor or a capacitive digital-to-analog converter (CDAC).

9. Circuit according to any one of the preceding claims, **characterised in that** in the coupling regions (14; 24; 34; 44) of each line arrangement in total at least two amplifying elements, preferably transistors, are arranged between the first conductor track (11; 21; 31; 41) and the second conductor track (12; 22; 32; 42).

10. Circuit according to any one of the preceding claims, **characterised in that** each line arrangement is designed in such a manner that in total a large proportion, preferably at least 1/3, of the total area occupied by the line arrangement is occupied by the first or the second conductor track.

11. Circuit according to any one of the preceding claims, **characterised in that** each line arrangement is designed in such a manner that the first conductor track (31; 41) and the second conductor track (32; 42) form at least two loops and the loops of the first conductor track lie partly within the loops of the second conductor track and partly embrace these.

12. Circuit according to any one of the preceding claims, **characterised in that** each line arrangement is designed in such a manner that the currents respectively flowing in directly adjacent conductor track sections when the high-frequency differential signal (x) is present at the differential input (IN) of the line arrangement are substantially without mutual displacement in any of the directly adjacent conductor track sections.

13. Circuit according to any one of the preceding claims, **characterised in that** each line arrangement has mutual coupling regions (15; 25; 35) in which in each instance a third section of the first or second conductor track is arranged at a greater second spacing from a directly adjacent fourth section of the first or second conductor track in such a manner that in the intermediate space between the third and fourth sections the magnetic fields produced by the currents flowing in the third and fourth sections displace one another only insubstantially when the high-frequency differential signal (x) is present at the differential input (IN) of the line arrangement, wherein the second spacing is greater than the first spacing.

14. Circuit according to claim 13, **characterised in that** the third and the fourth sections extend parallel to one another.

15. Circuit according to claim 13 or 14, **characterised in that** each line arrangement is designed in such a manner that the third and fourth sections together have a shorter overall length than the first and second sections together.

16. Circuit according to any one of claims 13 to 15, **characterised in that** the second spacing has a value which corresponds with two to six times, preferably three to five times, the value of the width of the first conductor track.

17. Circuit according to any one of the preceding claims, **characterised in that** the first conductor tracks (11; 21; 41) and the second conductor tracks (12; 22; 42) are each formed substantially symmetrically with respect to a point lying at one of the crossing regions (13; 23; 43).

18. Circuit according to any one of claims 1 to 16, **characterised in that** the first conductor tracks (31) and the second conductor tracks (32) are formed substantially symmetrically with respect to a plane (37) standing perpendicularly to the direction of propagation of the high-frequency differential signal (x).

19. Circuit according to any one of the preceding claims, **characterised in that** the circuit has at least two metallisation planes.

20. Circuit according to any one of the preceding claims, **characterised in that** the at least one first section and the at least one second section are flowed through by currents in the same sense or substantially same sense when the high-frequency differential signal (x) is present at the differential input (IN) of the line arrangement.

21. Circuit according to any one of the preceding claims, **characterised in that** the at least one first section and at least one second section extend at an angle of at most 45 degrees relative to one another.

22. Circuit according to any one of the preceding claims, **characterised in that** the at least one first section and at least one section extend at an angle of at most 30 degrees relative to one another.

## Revendications

1. Circuit intégré comprenant au moins une ligne de transmission intégrée pour la transmission d'un signal différentiel à haute fréquence (x), comprenant :
a) un nombre (N) d'au moins deux ensembles de lignes montés en série (10; 20; 30; 40) présentant chacun une entrée différentielle (IN), une sortie différentielle (OUT), un premier circuit conducteur (11; 21; 31; 41) relié à un premier pôle (IN+) de l'entrée différentielle et un premier pôle (OUT+) de la sortie différentielle et un deuxième circuit conducteur (12; 22; 32; 42) relié à un deuxième pôle(IN-) de l'entrée différentielle et un deuxième pôle (OUT-) de la sortie différentielle,
b) chaque ensemble de lignes présente au moins deux zones de croisement (13; 23; 33; 43) dans laquelle les premier et deuxième circuits conducteurs se croisent,
**caractérisé en ce que**
c) chaque ensemble de lignes présente au moins quatre zones de réaction positive (14; 24; 34; 44) dans chacune desquelles au moins une première section du premier circuit conducteur (11; 21; 31; 41) est disposée à une distance tellement faible par rapport à au moins une deuxième section du deuxième circuit conducteur (12; 22; 32; 42) que dans l'espace extérieur entourant les première et deuxième sections, les champs magnétiques générés par les courants (I1, 12) traversant les première et deuxième sections s'amplifient mutuellement lorsque le signal différentiel de haute fréquence (x) est appliqué à l'entrée différentielle (IN) de l'ensemble de lignes.

2. Circuit selon la revendication 1, **caractérisé en ce que** l'au moins une première section et l'au moins une deuxième section s'étendent parallèles ou sensiblement parallèles entre elles.

3. Circuit selon l'une quelconque des revendications précédentes, **caractérisé en ce que** les ensembles de lignes (10; 20; 30; 40) sont sensiblement identiques.

4. Circuit selon l'une quelconque des revendications précédentes, **caractérisé en ce que** chaque ensemble de lignes est conçu de telle manière que les première et deuxième sections présentent ensemble une longueur totale qui correspond à une grande part, de préférence au moins à un tiers, de la longueur totale du premier et du deuxième conducteur de cet ensemble de lignes.

5. Circuit selon l'une quelconque des revendications précédentes, **caractérisé en ce que** le premier intervalle prend une valeur représentant de 50 % à 200 %, de préférence 100 %, de la largeur du premier conducteur.

6. Circuit selon l'une quelconque des revendications précédentes, **caractérisé en ce que** dans les zones de réaction positive (14; 24; 34; 44) de chaque ensemble de lignes sont disposés au total au moins deux éléments capacitifs (26) entre le premier conducteur (11; 21; 31; 41) et le deuxième conducteur (12; 22; 32; 42).

7. Circuit selon la revendication 6, **caractérisé en ce que** les au moins deux éléments capacitifs (26) présentent un condensateur, de préférence un condensateur MIM.

8. Circuit selon la revendication 6 ou 7, **caractérisé en ce que** les au moins deux éléments capacitifs (26) présentent au moins un élément à capacité variable, de préférence un varactor ou un convertisseur capacitif numérique/analogique.

9. Circuit selon l'une quelconque des revendications précédentes, **caractérisé en ce que** dans les zones de réaction positive (14; 24; 34; 44) de chaque ensemble de lignes au moins deux éléments d'amplification, de préférence des transistors, sont disposés entre le premier conducteur (11; 21; 31; 41) et le deuxième conducteur (12; 22; 32; 42).

10. Circuit selon l'une quelconque des revendications précédentes, **caractérisé en ce que** chaque ensemble de lignes est conçu de telle manière qu'au total une grande partie, de préférence au moins 1/3, de l'espace total occupé par l'ensemble de lignes est occupé par le premier ou le deuxième conducteur.

11. Circuit selon l'une quelconque des revendications précédentes, **caractérisé en ce que** chaque ensemble de lignes est conçu de telle façon que le premier conducteur (31; 41) et le deuxième conducteur (32; 42) forment à chaque fois au moins deux boucles et **en ce que** les boucles du premier conducteur sont situées partiellement à l'intérieur des boucles du deuxième conducteur et entourent partiellement celles-ci.

12. Circuit selon l'une quelconque des revendications précédentes, **caractérisé en ce que** chaque ensemble de lignes est conçu de telle manière que les courants, qui circulent à chaque fois dans des sections de conducteurs directement voisines, lorsque le signal différentiel à haute fréquence (x) est appliqué à l'entrée différentielle (IN) de l'ensemble de lignes, ne se repoussent de manière importante dans aucune des sections de conducteurs directement voisines.

13. Circuit selon l'une quelconque des revendications précédentes, **caractérisé en ce que** chaque ensemble de lignes présente des zones de contre-réaction (15; 25; 35) dans lesquelles à chaque fois une troisième section du premier ou du deuxième conducteur sont disposées de telle manière à un deuxième intervalle plus grand par rapport à une quatrième section directement voisine du premier ou du deuxième conducteur, que dans l'espace intérieur entre les troisième et quatrième sections les champs magnétiques, générés par les courants qui circulent dans les troisième et quatrième sections, lorsque le signal différentiel à haute fréquence (x) est appliqué à l'entrée différentielle (IN) de l'ensemble de lignes, ne se repoussent que de manière insignifiante, le deuxième intervalle étant plus grand que le premier.

14. Circuit selon la revendication 13, **caractérisé en ce que** la troisième et la quatrième section s'étendent parallèles entre elles.

15. Circuit selon la revendication 13 ou 14, **caractérisé en ce que** chaque ensemble de lignes est conçu de telle manière que les troisième et quatrième sections présentent ensemble une longueur totale inférieure à celle que présentent ensemble les première et deuxième sections.

16. Circuit selon l'une quelconque des revendications 13 à 15, **caractérisé en ce que** la deuxième section prend une valeur correspondant à deux à six fois, de préférence trois à cinq fois, la largeur du premier conducteur.

17. Circuit selon l'une quelconque des revendications précédentes, **caractérisé en ce que** les premiers conducteurs (11; 21; 41)et les deuxièmes conducteurs (12; 22; 42) sont conçus chacun sensiblement symétriques par rapport à un point situé dans une des zones d'intersection (13; 23; 43).

18. Circuit selon l'une quelconque des revendications 1 à 16, **caractérisé en ce que** les premiers conducteurs (31) et les deuxièmes conducteurs (32) sont conçus chacun sensiblement symétriques à un plan (37) perpendiculaire à la direction d'extension du signal différentiel à haute fréquence (x).

19. Circuit selon l'une quelconque des revendications précédentes, **caractérisé en ce que** le circuit présente au moins deux plans de métallisation.

20. Circuit selon l'une quelconque des revendications précédentes, **caractérisé en ce que** l'au moins une première section et l'au moins une deuxième section sont parcourus par des courants dans le même sens ou sensiblement dans le même sens, lorsque le signal différentiel de haute fréquence (x) est appliqué à l'entrée différentielle (IN) de l'ensemble de lignes.

21. Circuit selon l'une quelconque des revendications précédentes, **caractérisé en ce que** l'au moins une première section et l'au moins une deuxième section s'étendent selon un angle de 45 degrés au maximum l'une par rapport à l'autre.

22. Circuit selon l'une quelconque des revendications précédentes, **caractérisé en ce que** l'au moins une première section et l'au moins une deuxième section s'étendent selon un angle de 30 degrés au maximum l'une par rapport à l'autre.
